# EUROPÄISCHE PATENTSCHRIFT

(11) **EP 2 668 511 B1**
(45) Veröffentlichungstag und Bekanntmachung des Hinweises auf die Patenterteilung: **15.04.2015**
(21) Anmeldenummer: 12710879.3
(22) Anmeldetag: 27.01.2012
(51) Int. Cl.: B29C 51/06, H04Q 9/00, G01R 15/14

(54) **ÜBERWACHUNGSANORDNUNG UND VERFAHREN ZUR ÜBERWACHUNG EINER ELEKTRISCHEN LEITUNG**
MONITORING SYSTEM AND METHOD OF MONITORING A POWER LINE
SYSTÈME DE SURVEILLANCE ET PROCÉDÉ POUR SURVEILLER UNE LIGNE ÉLECTRIQUE

(30) Priorität: 28.01.2011 DE 102011003308
(43) Veröffentlichungstag der Anmeldung: 04.12.2013
(73) Patentinhaber: Micropatent B.V., 7609 PK Almelo (NL)
(72) Erfinder: NURNUS, Joachim, 79395 Neuenburg (DE); VOLKERT, Fritz, CH-4104 Oberwil (CH); SCHMIDT, Martin, 79312 Emmendingen (DE)
(74) Vertreter: Staroske, Sandro
(86) Internationale Anmeldenummer: PCT/EP2012/051384
(87) Internationale Veröffentlichungsnummer: WO 2012/101271

(56) Entgegenhaltungen:
- EP-A1- 1 684 080
- US-A- 3 488 591
- US-A- 5 892 430
- US-A1- 2010 215 358

## Beschreibung

Die Erfindung betrifft eine Überwachungsanordnung zur Überwachung einer elektrischen Leitung gemäß Anspruch 1 sowie ein Verfahren zur Überwachung einer elektrischen Leitung gemäß Anspruch 15.

Aus dem Stand der Technik ist bekannt, an einer elektrischen Leitung, die z. B. einem Stromverteilsystem zugehört, mittels Infrarottechnik Momentaufnahmen der Temperatur des in der elektrischen Leitung geführten elektrischen Stromes zu erstellen. Mit dieser Technik ist jedoch z.B. eine kontinuierliche Überwachung des Stromverteilsystems nicht oder zumindest nur eingeschränkt möglich.

Eine Überwachungsanordnung zur Überwachung einer elektrischen Leitung gemäß dem Oberbegriff des Anspruchs 1 ist aus der EP 1 684 080 A1 bekannt.

Weitere Überwachungsanordnungen sind in den Dokumenten US 5 892 430 A, US 2010/215358 A1 und US 3 488 591 A offenbart.

Das von der Erfindung zu lösende Problem besteht darin, eine Überwachungsanordnung bereitzustellen, die eine möglichst effiziente Überwachung eines Stromverteilungssystems ermöglicht. Des Weiteren soll ein entsprechendes Verfahren angegeben werden.

Diese Probleme werden durch die Überwachungsanordnung gemäß Anspruch 1 sowie durch das Verfahren gemäß Anspruch 15 gelöst. Weiterbildungen der Erfindung sind in den abhängigen Ansprüchen angegeben.

Danach wird eine Überwachungsanordnung zur Überwachung einer elektrischen Leitung bereitgestellt, mit
- mindestens einem Thermogenerator und/oder einer Einrichtung zur induktiven Energiegewinnung;
- Bestimmungsmitteln zum Bestimmen mindestens einer elektrischen Kenngröße eines in der elektrischen Leitung fließenden elektrischen Stromes und/oder der der Temperatur der elektrischen Leitung und/oder der Umgebung der elektrischen Leitung, wobei
- zwischen den Bestimmungsmitteln und dem Thermogenerator oder der Einrichtung zur induktiven Energiegewinnung eine elektrische Verbindung besteht oder herstellbar ist, über die die Bestimmungsmittel mit von dem Thermogenerator erzeugter oder von der Einrichtung zur induktiven Energiegewinnung bereitgestellter elektrischer Energie betreibbar sind; und
- Verbindungsmitteln zum Herstellen einer mechanischen Verbindung mit der elektrischen Leitung, wobei
- die Verbindungsmittel einen aus einem elektrisch isolierenden Material gebildeten oder eine elektrisch isolierende Beschichtung aufweisenden Anlagebereich aufweisen, der an einer sowohl den Bestimmungsmitteln als auch dem Thermogenerator und/oder der Einrichtung zur induktiven Energiegewinnung abgewandten Seite der elektrischen Leitung zur Anlage gebracht werden kann.

Da die Bestimmungsmittel über die vom Thermogenerator und/oder der Einrichtung zur induktiven Energiegewinnung zur Verfügung gestellten elektrische Energie gespeist werden können, kann eine zumindest im Wesentlichen autarke Überwachungsanordnung bereitgestellt werden, wodurch z.B. weniger Wartungs- und Instandhaltungsmaßnahmen anfallen, ganz entfallen oder präventive Maßnahmen reduziert werden können. Beispielsweise werden die Bestimmungsmittel ausschließlich mittels der vom Thermogenerator und/oder der Einrichtung zur induktiven Energiegewinnung erzeugten Energie betrieben.

Insbesondere kann mit der erfindungsgemäßen Überwachungsanordnung ein möglichst kontinuierliches Überwachen (Monitoring) der stromführenden elektrischen Leitung und/oder eine Echtzeitüberwachung erfolgen, z.B. um kritische Situationen (etwa eine zu hohe Stromstärke) rechzeitig erkennen zu können. Des Weiteren ist denkbar, dass über das Monitoring zumindest einer elektrischen Kenngröße des in der Leitung geführten Stromes eine Steuerung eines Stromverteilsystems, z. B. einer Produktionsstätte oder - anlage oder eines Gebäudes (etwa eines Einkaufszentrums oder eines Flughafens etc.), erfolgt, wobei das Stromverteilsystem z.B. eine Schaltschrankanlage und die zu überwachende elektrische Leitung eine Stromschiene ist. Die erfindungsgemäße Überwachungsanordnung kann jedoch zum Beispiel auch zur Überwachung einer Überlandleitung eines Überlandstromnetzes verwendet werden.

Die elektrische Verbindung zwischen den Bestimmungsmitteln und dem Thermogenerator und/oder der Einrichtung zur induktiven Energiegewinnung ist insbesondere durch eine elektrische Leitung (z.B. eine Leiterbahn oder ein Kabel) realisiert. Beispielsweise weisen die Bestimmungsmittel einen elektrischen Anschluss oder einen Schaltungsknoten auf, mit dem die elektrische Leitung zwischen den Bestimmungsmitteln und dem Thermogenerator und/oder der Einrichtung zur induktiven Energiegewinnung verbunden ist. Es ist allerdings auch möglich, dass die elektrische Energie vom Thermogenerator und/oder der Einrichtung zur induktiven Energiegewinnung zur Versorgung der Bestimmungsmittel nicht per Leitung, sondern drahtlos an die Bestimmungsmittel übertragen wird (insbesondere per induktiver Kopplung).

Wie oben bereits erwähnt, können die Bestimmungsmittel ausschließlich durch die vom Thermogenerator (bzw. von mehreren Thermogeneratoren) und/oder der Einrichtung zur induktiven Energiegewinnung erzeugte elektrische Energie betrieben werden. Es ist jedoch auch denkbar, dass die Überwachungsanordnung zusätzlich zu dem mindestens einen Thermogenerator und/oder der Einrichtung zur induktiven Energiegewinnung mindestens eine Primärenergiequelle (z. B. eine Batterie) aufweist, die zu dem Thermogenerator bzw. der Einrichtung zur induktiven Energiegewinnung hinzugeschaltet werden kann. Es ist natürlich auch möglich, dass zusätzlich mindestens eine Sekundärenergiequelle (z.B. eine aufladbare Batterie) vorgesehen ist, die z.B. durch den Thermogenerator und/oder der Einrichtung zur induktiven Energiegewinnung aufgeladen werden kann, oder eine Kombination aus mindestens einer Primärenenergiequelle und mindestens einer Sekundärenergiequelle.

Die Energieversorgung der Bestimmungsmittel erfolgt somit zumindest teilweise über den Thermogenerator und/oder über die Einrichtung zur induktiven Energiegewinnung, wobei der Thermogenerator aufgrund eines Temperaturgradienten im Bereich der elektrischen Leitung Energie erzeugt und die Einrichtung zur induktiven Energiegewinnung Energie aus einem magnetischen Wechselfeld, das um die elektrische Leitung herum vorhanden ist, gewinnt. Die Einrichtung zur induktiven Energiegewinnung umfasst beispielsweise einen induktiven Aufnehmer (umfassend z.B. mindestens eine Spule), die mit dem magnetischen Feld der elektrischen Leitung wechselwirkt. Insbesondere ist die Position der Spule des induktiven Aufnehmers relativ zum Leiter bekannt, um aus dem Signal des Aufnehmers auf den Strom schließen zu können.

Der Thermogenerator liefert z.B. auch nach einer Unterbrechung des Stromflusses in der Leitung noch Strom, da die Leitung innerhalb einer gewissen Zeitspannung nach Stromabschaltung noch warm sein kann.

Die Verbindungsmittel, über die die Überwachungsanordnung mit der elektrischen Leitung (insbesondere lösbar) mechanisch verbindbar ist, sind insbesondere zum Herstellen einer kraft- und/oder formschlüssigen Verbindung mit der elektrischen Leitung ausgebildet. Beispielsweise lässt sich über die Verbindungsmittel eine Klemmverbindung der Überwachungsanordnung mit der elektrischen Leitung herstellen. In einer anderen Variante bilden die Verbindungsmittel eine stoffschlüssige Verbindung, insbesondere eine Klebverbindung, zwischen der Überwachungsanordnung und der elektrischen Leitung her.

Denkbar ist darüber hinaus, dass die Verbindungsmittel so ausgebildet sind, dass sie nach Herstellen der Verbindung zumindest mit einem Abschnitt an der elektrischen Leitung anliegen, wobei über den an der elektrischen Leitung anliegenden Abschnitt keine elektrische Verbindung zwischen der elektrischen Leitung und den Bestimmungsmitteln entsteht. Die Verbindungsmittel dienen somit ausschließlich zum Herstellen einer mechanischen Verbindung und nicht zum Herstellen einer elektrischen Verbindung zu der elektrischen Leitung.

Beispielsweise weisen die Verbindungsmittel nach Art einer Klammer einen Arm auf, der gegenüber einem Träger, an dem der Thermogenerator und/oder die Einrichtung zur induktiven Energiegewinnung angeordnet ist, bewegbar ist. Die Überwachungsanordnung wird dann so an der elektrischen Leitung positioniert, dass die Leitung zwischen dem Träger (der z.B. auch durch ein Gehäuseteil abgedeckt sein kann) und dem Arm verläuft, wobei durch Verstellen des Armes der Abstand zwischen dem Träger und dem Arm auf den Durchmesser der Leitung eingestellt werden kann. Nach Positionieren der Überwachungsanordnung an der Leitung wird der Arm auf die Leitung zu bewegt, bis der Anlageabschnitt an der Leitung anliegt, wobei z.B. diese Position des Armes über Fixiermittel (z.B. in Form einer Feststellschraube) oder über Raststrukturen fixiert werden kann.

Es ist auch möglich, dass der Arm gegenüber dem Träger vorgespannt ist, wobei der Arm zum Befestigen der Überwachungsanordnung an der elektrischen Leitung von dem Träger mit dem Thermoelement gegen die Vorspannung wegbewegt und die Überwachungsanordnung so an der elektrischen Leitung angeordnet wird, dass sich die Leitung zwischen dem Träger und dem Arm befindet. Der Arm wird sich nun aufgrund seiner Vorspannung an einem dem Thermogenerator bzw. der Einrichtung zur induktiven Energiegewinnung abgewandten Seitenabschnitt der elektrischen Leitung anlegen. Beispielsweise wird der Anlagebereich durch eine drahtförmige Klammer der Verbindungsmittel ausgebildet.

Die Klammer ist z.B. multifunktional und erlaubt z.B. eine einfache, schnelle und flexible Montage mit einer Hand. Insbesondere fixiert die Klammer die Überwachungsvorrichtung so an der elektrischen Leitung, dass neben einem guten mechanischen Halt (z.B. kein Abfallen bei Erschütterungen) auch ein guter thermischer Kontakt hergestellt wird.

Es sind selbstverständlich auch andere Ausgestaltungen der Verbindungsmittel denkbar; z. B. können die Verbindungsmittel zusätzlich oder alternativ zu den beschriebenen Varianten auch zum Herstellen einer Magnetverbindung zwischen der Überwachungsanordnung und der elektrischen Leitung ausgebildet sein.

Gemäß einer anderen Weiterbildung der Erfindung weist die Überwachungsanordnung Übertragungsmittel zum drahtlosen Übertragen der erfassten elektrischen Kenngröße und/oder einer Information bezüglich der erfassten elektrischen Kenngröße an eine Empfangseinrichtung auf. Die Empfangseinrichtung ist beispielsweise eine speziell zur Kommunikation mit den Übertragungsmitteln der Überwachungsanordnung ausgebildete Empfangseinheit. Es ist jedoch auch denkbar, dass die Empfangseinrichtung ein auch für andere Aufgaben einsetzbares Endgerät ist, z. B. ein PC oder ein Mobiltelefon, und die Übertragungsmittel Informationen an dieses Endgerät senden, z. B. per Textnachricht (SMS) oder über das Internet.

Die Übertragungsmittel werden beispielsweise (insbesondere ausschließlich) mit der vom Thermogenerator und/oder der Einrichtung zur induktiven Energiegewinnung erzeugten Energie betrieben.

Des Weiteren kann die Überwachungsanordnung einen Energiespeicher zum Speichern von elektrischer Energie aufweisen, die vom Thermogenerator und/oder der Einrichtung zur induktiven Energiegewinnung erzeugt wird. In dem Energiespeicher wird insbesondere Energie gespeichert, die zum Zeitpunkt der Erzeugung nicht von den Bestimmungsmitteln der Überwachungsanordnung benötigt wird. Der Energiespeicher ermöglicht insbesondere, dass die Bestimmungsmittel auch dann mit ausreichender Energie versorgt werden können, wenn der Thermogenerator bzw. die Einrichtung zur induktiven Energiegewinnung vorübergehend keine für den Betrieb der Bestimmungsmittel ausreichende Energiemenge erzeugt. Der Energiespeicher weist beispielsweise mindestens einen Kondensator (z. B. in Form eines "Supercap"-Kondensators) oder eine Batterie (z. B. eine Dünnschichtbatterie - TFB - "Thin Film Battery") auf. Ein Energiespeicher kann entfallen, falls die Überwachungsanordnung, wie oben erwähnt, zusätzlich zu dem Thermogenerator und/oder der Einrichtung zur induktiven Energiegewinnung eine Primärenergiequelle aufweist. Allerdings ist es natürlich auch möglich, sowohl einen Energiespeicher als auch eine Primärenergiequelle vorzusehen.

Gemäß einer weiteren Ausgestaltung der Erfindung weist der Energiespeicher erste und zweite Speichermittel auf, wobei die zweiten Speichermittel eine höhere Speicherkapazität besitzen als die ersten Speichermittel. Die ersten Speichermittel können Bestandteil einer elektronischen Schaltung sein, die insbesondere dazu dient, die vom Thermogenerator und/oder der Einrichtung zur induktiven Energiegewinnung erzeugte oder die von den zweiten Speichermitteln bereitgestellte Spannung aufzubereiten.

Beispielsweise handelt es sich bei den ersten Speichermitteln um einen mit einer DC-Booster-Schaltung (Aufwärtswandlerschaltung) verbundenen Kondensator. Die von diesem Kondensator bereitgestellte Spannung und die darin gespeicherte Energie sind insbesondere ausreichend, um den Anlauf der Booster-Schaltung zu ermöglichen. Die zweiten Speichermittel mit der größeren Kapazität dienen dann nicht dem Betrieb der Booster-Schaltung, sondern speichern zusätzliche Energie, die dem Betrieb der restlichen Stufen der Ueberwachungsanordnung zur Verfügung steht. Dieser Hauptenergiespeicher kann so ausgelegt sein, dass er überschüssige Energie des Thermogenerators und/oder der Einrichtung zur induktiven Energiegewinnung, welche die Überwachungsanordnung zu diesem Zeitpunkt nicht benötigt, ganz oder teilweise speichert. Es wird darauf hingewiesen, dass der Energiespeicher selbstverständlich auch unterschiedliche Elemente, die zum Speichern von elektrischer Energie in Frage kommen, aufweisen kann, z. B. mindestens einen Kondensator und mindestens eine Batterie.

Darüber hinaus kann die Überwachungsanordnung Mittel aufweisen, die die Verwertung der vom Thermogenerator und/oder der Einrichtung zur induktiven Energiegewinnung erzeugten Energie steuern. Beispielsweise bestimmen diese Mittel, welcher Anteil der erzeugten Energie gespeichert und welcher Anteil den Bestimmungsmittel oder sonstigen Komponenten der Überwachungsanordnung zur Verfügung gestellt wird ("Power Management").

Die Überwachungsanordnung kann neben den Bestimmungsmitteln zum Bestimmen einer elektrischen Kenngröße des Stromes auch zum Ermitteln der Temperatur der elektrischen Leitung ausgebildet sein (und kann hierfür z.B. einen separaten Sensor aufweisen). Insbesondere kann ein derartiger Temperatursensor dazu ausgebildet sein, ein Alarmsignal zu erzeugen, falls die Temperatur der elektrischen Leitung einen vorgebbaren Grenzwert übersteigt. Des Weiteren ist eine Plausibilitätsprüfung der mit den Bestimmungsmitteln bestimmten elektrischen Kennwerte möglich; z. B. wird bei einem Anstieg des elektrischen Stromes in der Leitung ein Anstieg auch der Temperatur erwartet. Darüber hinaus kann mit dem Temperatursensor natürlich auch die Umgebung der elektrischen Leitung überwacht und z.B. bei einem Brand ein Alarmsignal ausgelöst werden.

Beispielsweise ist der Temperatursensor beabstandet zu dem Thermogenerator und/oder der Einrichtung zur induktiven Energiegewinnung, d.h. beabstandet zu einem Wärmepfad, der von der elektrischen Leitung durch den Thermogenerator und/oder der Einrichtung zur induktiven Energiegewinnung hindurch verläuft, anzuordnen, um eine Beeinflussung der Temperaturmessung z.B. durch einen Kühlkörper der Überwachungsvorrichtung möglichst gering zu halten. Denkbar ist z.B., dass der Temperatursensor die Temperatur im Innern der elektrischen Leitung durch Extrapolation der (z.B. an der Oberfläche der Leitung und/oder in der Umgebung der Leitung) mit dem Temperatursensor gemessenen Temperatur ermittelt wird.

Darüber hinaus kann die Überwachungsanordnung auch Mittel aufweisen, die zur Auswertung der über die Bestimmungsmittel bestimmten elektrischen Kenngröße dienen und z. B. die von den Bestimmungsmitteln gelieferten Daten so aufbereiten, dass einem Nutzer (Stromkunde) Informationen über die von ihm bezogene Strommenge und andere Daten bezüglich des Stromes (z.B. die entsprechenden Stromkosten, d. h. eine Verbrauchsinformation) übermittelt werden können.

Die Bestimmungsmittel sind insbesondere dazu ausgebildet, (mittelbar und/oder unmittelbar) die Stromstärke des in der elektrischen Leitung geführten elektrischen Stromes zu ermitteln. Hierfür sind aus dem Stand der Technik Verfahren bekannt, die in den Bestimmungsmitteln realisiert sein können; z.B. bestimmen die Bestimmungsmittel den Strom über ein Magnetfeld der elektrischen Leitung und weisen hierzu insbesondere mindestens einen Hall-Sensor, mindestens einen elektro-resistiven Sensor, und/oder mindestens einen induktiven Sensor auf. Des Weiteren können die Bestimmungsmittel zusätzlich oder alternativ auch dazu ausgebildet sein, eine Spannungsdifferenz zwischen zwei Punkten der elektrischen Leitung zu bestimmen, wobei z. B. auch aus dieser Spannungsdifferenz die Stromstärke bestimmbar ist. Die Bestimmungsmittel können auch durch die Einrichtung zur induktiven Energiegewinnung gebildet sein, d.h. die Einrichtung zur induktiven Energiegewinnung bildet einen Sensor aus, der sich aus Energie des magenetischen Wechselfeldes der Leitung speist.

Des Weiteren ist denkbar, dass die Bestimmungsmittel auch eine elektrische Spannung der elektrischen Leitung gegenüber einem zur elektrischen Leitung externen Referenzpunkt (z.B. gegenüber Erde oder gegenüber einer anderen elektrischen Leitung) bestimmen können, z. B. per "Magnetic Field Technology" des Anbieters "Suparule".

In einem anderen Beispiel der Erfindung sind die Bestimmungsmittel auch in der Lage, bei einem in der elektrischen Leitung geführten Wechselstrom die Phase zwischen Strom und Spannung zu erfassen. Darüber hinaus können die Bestimmungsmittel Auswertemittel aufweisen, die die erfasste elektrische Kenngröße verarbeiten; zum Beispiel aus der ermittelten Phase einen Blindstromanteil bestimmen und/oder eine Fouriertransformation auf das Kenngrößensignal anwenden. Selbstverständlich kann eine derartige Auswertung des Kenngrößensignals auch in einer nicht an der elektrischen Leitung angeordneten Auswerteeinheit vorgenommen werden, wobei z.B. das bestimmte Kenngrößensignal von Übertragungsmitteln der Überwachungsanordnung an diese Auswerteeinheit drahtlos übermittelt wird.

Des Weiteren können die Bestimmungsmittel ausgebildet sein, die elektrische Kenngröße zeitabhängig zu bestimmen, d.h. die elektrische Kenngröße insbesondere intervallweise zu ermitteln, wobei die Intervalle zwischen zwei aufeinanderfolgenden Messungen so kurz (beispielsweise 1 Minute) gewählt werden können, dass eine ausreichend kontinuierliche Ermittlung der elektrischen Kenngröße erfolgt.

Darüber hinaus können die Bestimmungsmittel ausgebildet sein, Abweichungen von einer vorgebbaren Signalform (d.h. dem zeitlichen Verlauf mindestens einer elektrischen Kenngröße des in der Leitung geführten Stromes) zu ermitteln. Beispielsweise ist die vorgebbare Signalform ein Sinusverlauf, wobei die Bestimmungsmittel in der Lage sind, Abweichungen von dem erwarteten Sinusverlauf hinsichtlich der Frequenz, Amplitude und/oder Phase zu bestimmen.

Es ist natürlich auch möglich, dass der zeitliche Verlauf des Signals lediglich erfasst wird (insbesondere mit einer Samplingrate, die deutlich höher ist als die Frequenz des Signals), ohne das Signal zu analysieren und das Signal lediglich zu speichern und / oder zu kommunizieren. Die Erfassung des Signals kann auch in Intervallen und jeweils für eine bestimmte Zeit erfolgen (z.B. wird das Signal jede Minute eine Sekunde lang erfasst, so dass etwa bei einer Signalfrequenz von 50 Hz jeweils 50 Perioden erfasst werden).

Darüber hinaus können die Bestimmungsmittel auch ausgebildet sein, Abweichungen von einem DC-Signal (Gleichstromsignal) zu ermitteln. Insbesondere sind die Bestimmungsmittel ausgebildet, die Frequenz, das Frequenzspektrum und/oder eine Amplitude der elektrischen Kenngröße und/oder wie erwähnt einen Blindstromanteil des elektrischen Stromes zu bestimmen. Beispielsweise sind die Bestimmungsmittel ausgebildet, ein Alarmsignal zu generieren, falls die Frequenz, die Amplitude und/oder der Blindstromanteil um einen vorgebbaren Mindestwert von einem Referenzwert abweichen.

Beispielsweise wird durch einen Fehler in einem Stromverteilsystem oder durch eine Beschädigung der elektrischen Leitung die Signalform der aufgeprägten elektrischen Spannung (und damit des durch die elektrische Leitung fließenden Stromes) verändert. Insbesondere verändern sich die Frequenz der Spannung bzw. des Stromes und/oder die Amplitude, so dass eine Abweichung dieser Größen von einem jeweiligen Referenzwert einen Hinweis auf einen Fehlerzustand und/oder auf eine drohende Netzinstabilität liefern kann. Im Falle eines Gleichstroms kann das Vorhandensein von Störfrequenzen im Frequenzspektrum ebenfalls auf das Vorliegen eines Fehlers oder auf einen Defekt der Leitung hinweisen. Insbesondere kann durch Analyse des zeitlichen Verlaufs der elektrischen Kenngröße auf die Ursache des Fehlers geschlossen werden.

Gemäß einer anderen Ausgestaltung der Erfindung weist die Überwachungsanordnung Umschaltmittel auf, über die die Bestimmungsmittel aus einem ersten, energiesparenden Zustand in einen zweiten, aktiven Zustand schaltbar sind. Über die Umschaltmittel können die Bestimmungsmittel (oder, falls vorhanden, auch die Übertragungsmittel zum drahtlosen Übertragen der ermittelten Kenngröße) z.B. aus einem Ruhezustand "aufgeweckt" werden. "Energiesparend" bedeutet, dass die Bestimmungsmittel im ersten Zustand weniger elektrische Energie verbrauchen als im zweiten Zustand, wobei unter dem "ersten, energiesparenden Zustand" beispielsweise auch ein Aus- oder ein Stand-by-Zustand der Bestimmungsmittel verstanden wird. Zudem können die Umschaltmittel auch dazu dienen, die Bestimmungsmittel aus dem aktiven Zustand in den energiesparenden Zustand zu schalten.

Des Weiteren kann die Überwachungsanordnung auch einen internen Speicher aufweisen, der Informationen (Daten) bezüglich der erfassten elektrischen Kenngröße speichert. Insbesondere ermöglicht dieser Speicher ein Speichern von Daten für den Fall, dass eine Verbindung der Überwachungsanordnung zu einer externen Empfangseinheit (die sonst beispielsweise über eine drahtlose Verbindung existiert) ausgefallen ist.

Des Weiteren kann die Überwachungsanordnung ausgebildet sein, optische und/oder akustische Signale zu generieren, die eine Aktivität oder eine sonstige Statusinformation bezüglich der Überwachungsanordnung signalisieren. Beispielsweise weist die Überwachungsanordnung zudem ein Display zur Darstellung von Informationen (z.B. bezüglich des Status der Überwachungsanordnung und/oder bezüglich der ermittelten elektrischen Kennwerte) auf. Darüber hinaus kann die Überwachungsanordnung auch Mittel zum Erzeugen eines optischen Signals aufweisen, das zur Kennzeichnung der elektrischen Leitung (zum Beispiel bei einer Überlandleitung) oder zum Erleichtern des Auffindens der Überwachungsanordnung dient.

Gemäß einem weiteren Ausführungsbeispiel weist die Überwachungsanordnung ein Gehäuse aus einem elektrisch isolierenden Material auf, in dem der mindestens eine Thermogenerator und/oder der Einrichtung zur induktiven Energiegewinnung und/oder die Bestimmungsmittel angeordnet sind, so dass ein elektrischer Kontakt zwischen der elektrischen Leitung und diesen Komponenten der Überwachungsanordnung verhindert wird.

In einem anderen Beispiel weist die Überwachungsanordnung einen an der Kaltseite des Thermogenerators angeordneten Kühlkörper (Wärmesenke) auf, wobei sich auf einer dem Thermogenerator abgewandten Seite des Kühlkörpers ein Isolierelement erstreckt, das insbesondere einen elektrischen Kontakt des Kühlkörpers mit einem anderen stromführenden Element (z.B. einer benachbarten elektrischen Leitung) verhindern soll.

Die elektrische Isolierung kann auch durch einen elektrisch nicht leitenden Kühlkörper realisiert werden.

Darüber hinaus kann die Heißseite des Thermogenerators nach Montage der Überwachungsanordnung über einen Wärmeverteiler ("Heat Spreader") mit der elektrischen Leitung in thermischem Kontakt stehen. Es ist natürlich auch denkbar, dass die Kaltseite des Thermogenerators unmittelbar (d.h. ohne ein Zwischenelement wie den Wärmeverteiler) in Kontakt mit der elektrischen Leitung gebracht wird.

Die mit der elektrischen Leitung in Kontakt zu bringende Oberfläche des Wärmeverteilers oder des Thermogenerators kann so gestaltet sein, dass sie an verschiedene Oberflächekonturen anpassbar ist. Denkbar ist, dass die Oberfläche des Wärmeverteilers zumindest abschnittsweise aus einem flexiblen oder elastischen Material besteht. Des Weiteren könnte auch ein Anpasselement vorgesehen sein, das zwischen dem Wärmeverteiler und dem elektrischen Leiter angeordnet wird, wobei das Anpasselement eine erste Oberfläche aufweist, die korrespondierend zur Oberfläche des Wärmeverteilers ausgebildet ist, und eine zweite Oberfläche, die korrespondierend zur Oberfläche der elektrischen Leitung ausgebildet ist.

Die Erfindung betrifft auch eine Anordnung aufweisend mindestens eine elektrische Leitung und mindestens eine wie oben beschriebene, an der elektrischen Leitung angeordnete Überwachungsanordnung.

Beispielsweise umfasst die Anordnung eine Mehrzahl derartiger Überwachungsanordnungen, wobei jede der Überwachungsanordnungen Übertragungsmittel zum drahtlosen Übertragen der von den Bestimmungsmitteln bestimmten elektrischen Kenngröße und/oder einer Information bezüglich der bestimmten elektrischen Kenngröße an eine Empfangseinrichtung aufweist, und wobei die Übertragungsmittel ausgebildet sind, Signale der Übertragungsmittel der anderen Überwachungsanordnungen zu empfangen und diese Signale an mindestens eine andere Überwachungsanordnung oder an die Empfangseinrichtung zu übermitteln. Somit wird eine Redundanz der Übertragungsmittel geschaffen und gleichzeitig die Reichweite der drahtlosen Übertragung erhöht.

Die Erfindung betrifft auch ein Verfahren zur Überwachung einer elektrischen Leitung, mit den Schritten
- Bereitstellen einer Überwachungsanordnung, die insbesondere gemäß einem der oben beschrieben Ausgestaltungen ausgebildet ist, wobei die Überwachungsanordnung mindestens einen Thermogenerator und/oder eine Einrichtung zur induktiven Energiegewinnung aufweist sowie Bestimmungsmittel zum Bestimmen mindestens einer elektrischen Kenngröße eines in der elektrischen Leitung fließenden elektrischen Stromes und/oder der Temperatur der elektrischen Leitung und/oder der Umgebung der elektrischen Leitung, wobei zwischen den Bestimmungsmitteln und dem Thermogenerator eine elektrische Verbindung besteht oder herstellbar ist, über die die Bestimmungsmittel mit von dem Thermogenerator erzeugter oder von der Einrichtung zur induktiven Energiegewinnung bereitgestellter elektrischer Energie betreibbar sind; und
- Herstellen einer mechanischen Verbindung zwischen der Überwachungsanordnung und der elektrischen Leitung mittels Verbindungsmitteln, die einen aus einem elektrisch isolierenden Material gebildeten oder eine elektrisch isolierende Beschichtung aufweisenden Anlagebereich aufweisen, der an einer sowohl den Bestimmungsmitteln als auch dem Thermogenerator und/oder der Einrichtung zur induktiven Energiegewinnung abgewandten Seite der elektrischen Leitung zur Anlage gebracht wird.

Insbesondere ist denkbar, dass die mit elektrischer Energie des Thermogenerators und/oder der Einrichtung zur induktiven Energiegewinnung betriebenen Bestimmungsmittel nicht zum Bestimmen von elektrischen Kenngrößen des in der Leitung geführten Stromes, sondern nur zur Bestimmung der Temperatur der Leitung und/oder ihrer Umgebung ausgebildet sind. In diesem Fall ist möglich, dass zusätzlich eine Messung von elektrischen Kenngrößen des Stromes über einen konventionellen Stromsensor (der nicht über den Thermogenerator und/oder die Einrichtung zur induktiven Energiegewinnung mit Energie versorgt wird) erfolgt. Insbesondere weisen die Bestimmungsmittel einen wie oben in Zusammenhang mit der Überwachungsvorrichtung beschrieben ausgebildeten Temperatursensor auf.

Darüber hinaus ist es möglich, dass der Temperatursensor in einem Abstand zu der elektrischen Leitung angeordnet wird. Zusätzlich oder alternativ können die Bestimmungsmittel einen Temperatursensor aufweisen, der zum Bestimmen der Temperatur der Leitung dicht an dieser positioniert wird oder so angeordnet wird, dass er an der elektrischen Leitung anliegt.

Die Erfindung wird im Folgenden anhand von Ausführungsbeispielen unter Bezugnahme auf die Figuren näher erläutert. Es zeigen:
- Fig. 1: eine Draufsicht einer an einer Stromschiene angeordneten Überwachungsanordnung gemäß einer Ausführungsform der Erfindung;
- Fig. 2: die Überwachungsanordnung aus Fig. 1 in perspektivischer Darstellung;
- Fig. 3: eine andere perspektivische Darstellung der Überwachungsanordnung aus den Fig. 1 und 2;
- Fig. 4: die Überwachungsanordnung aus den Figuren 1 bis 3 bei entferntem Gehäuse;
- Fig. 5: eine an einer elektrischen Leitung angeordnete Überwachungsanordnung gemäß einer weiteren Ausführungsform der Erfindung;
- Fig. 6: schematisch eine an einer Überlandleitung angeordnete erfindungsgemäße Überwachungsanordnung; und
- Fig. 7A und 7B: Draufsichten einer Überwachungsanordnung gemäß einem weiteren Ausführungsbeispiel der Erfindung.

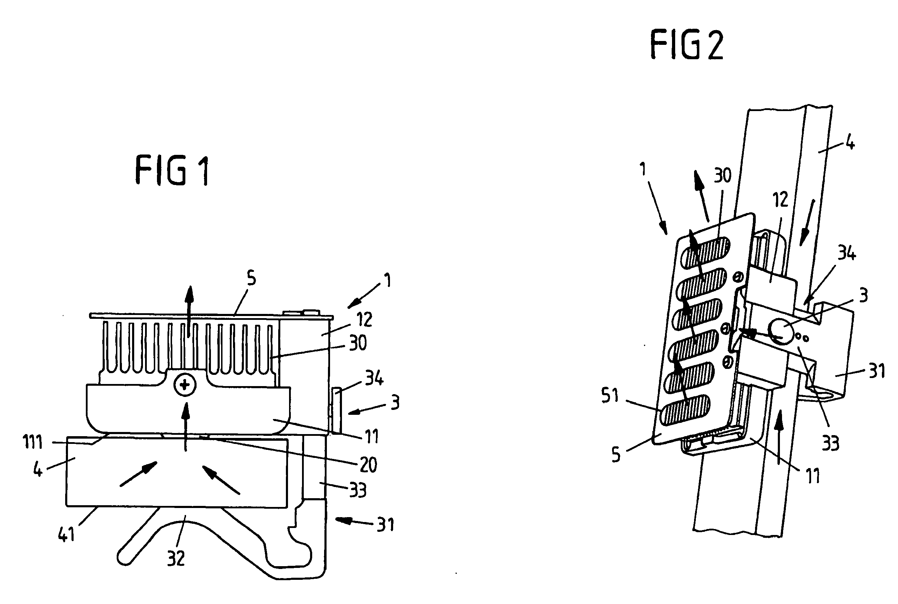

Die in Fig. 1 dargestellte erfindungsgemäße Überwachungsanordnung 1 umfasst zwei in einem elektrisch isolierenden Gehäuseteil 11 angeordnete Thermogeneratoren (durch das Gehäuseteil 11 verdeckt), deren Heißseiten jeweils mit einem aus dem Gehäuseteil 11 herausragenden Wärmeverteiler ("Heat Spreader") 20 in thermischem Kontakt stehen. Die Kaltseiten der Thermogeneratoren sind mit einer Wärmesenke in Form eines Lamellenkühlers 30 thermisch gekoppelt.

Die Überwachungsanordnung 1 weist des Weiteren Verbindungsmittel 3 auf, über die die Überwachungsanordnung an einer elektrischen Leitung in Form einer Stromschiene 4 befestigt ist, wobei Fig. 1 die Stromschiene 4 in Schnittdarstellung zeigt. Die Verbindungsmittel 3 umfassen einen senkrecht zur Haupterstreckungsrichtung der Stromschiene 4 (und entsprechend auch senkrecht zu einem der Stromschiene zugewandten Bodenabschnitt 111 des Gehäuseteils 11) verschiebbaren Arm 31. Der Arm 31 weist einen Abschnitt 33 auf, der sich im Wesentlichen entlang der Verschiebungsrichtung (d.h. senkrecht zum Bodenabschnitt 111 des Gehäuseteils 11) erstreckt und der in einem seitlich an das Gehäuseteil 11 angrenzenden weiteren Gehäuseteil 12 verschiebbar gelagert ist. Insbesondere ist der Abschnitt 33 nach Art einer Schiene in einem Kanal des Gehäuseteils 12 verschiebbar geführt. Die Gehäuseteile 11 und 12 sind z.B. einstückig miteinander verbunden.

Der Arm 31 besitzt darüber hinaus einen gekrümmten Anlagebereich 32, wobei durch Verschieben des Armes der Abstand zwischen dem Bodenbereich 111 (und dem Wärmeverteiler 20) und dem Anlagebereich 32 verändert und auf den Durchmesser der Stromschiene, d.h. auf die Höhe der im Querschnitt rechteckigen Stromschiene, eingestellt werden kann. Nach Anordnen der Überwachungsanordnung an der Stromschiene derart, dass diese sich zwischen dem Bodenabschnitt 111 des Gehäuseteils 11 und dem Anlagebereich 32 des Armes 31 befindet, wird der Arm auf die Stromschiene zu verschoben, bis der Anlagebereich 32 an einer dem Bodenabschnitt 111 (und damit auch dem Wärmeverteiler 20) abgewandten Seite 41 der Stromschiene 4 zur Anlage kommt. Der Arm 31 ist mittels einer Feststellschraube 34 in dieser Position fixierbar, so dass der Arm 31 ein Abkippen der Überwachungsanordnung von der Stromschiene verhindert.

Die Schraube 34 wird zum Fixieren des Armes in eine von mehreren in dem Armabschnitt 33 vorhandenen Durchgangsbohrungen (vgl. Fig. 2) eingesteckt und festgezogen. Die Durchgangsbohrungen weisen z.B. jeweils einen Abstand zueinander von 5 mm auf, so dass die Überwachungsanordnung an Stromschienen mit Höhen von 5, 10, 15 und 20 mm angeordnet werden kann. Selbstverständlich sind diese Werte nur beispielhaft und die Überwachungsanordnung kann auch an andere Stromschienengeometrien (z.B. auch stufenlos) angepasst werden. Insbesondere kann der Arm 31 auch zum Anordnen an Stromschienen oder anderen elektrischen Leitungen, die keinen rechteckigen Querschnitt aufweisen, ausgebildet sein.

Des Weiteren kann durch das Anliegen des Anlagebereichs 32 des Armes 31 auch eine Klemmung zwischen der Überwachungsanordnung 1 und der Stromschiene 4 hergestellt sein, wobei aufgrund der Reibungskraft zwischen dem Anlagebereich 32 und der Stromschiene 4 einer Bewegung der Überwachungsanordnung längs der Stromschiene entgegengewirkt wird.

Selbstverständlich ist die in den Fig. 1 bis 3 dargestellte Ausgestaltung der Verbindungsmittel 3 nur beispielhaft. Es sind vielfältige Varianten denkbar, um eine Verbindung der Überwachungsanordnung mit der Stromschiene zu realisieren; beispielsweise muss der Anlagebereich 32 des Armes nicht gekrümmt verlaufen. Des Weiteren könnte auch ein Arm 31 vorgesehen sein, der gegenüber dem Gehäuseteil 11 vorgespannt ist, so dass eine Fixierung der Überwachungsanordnung dadurch zustande kommt, dass nach Anordnen der Überwachungsanordnung an der Stromschiene der Anlagebereich 32 des Armes aufgrund der Vorspannung gegen die untere Seite 41 der Stromschiene 4 drückt.

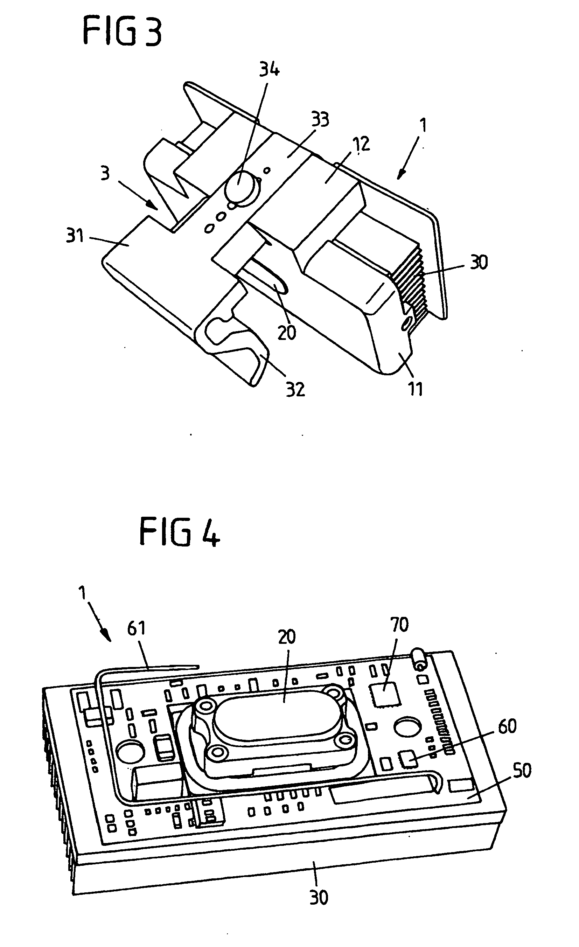

In dem Gehäuseteil 11 sind neben den beiden Thermogeneratoren auch Bestimmungsmittel in Form eines Stromsensors angeordnet, die zur Messung elektrischer Kenngrößen (zum Beispiel Strom und/oder Spannung) eines in der Stromschiene 4 geführten elektrischen Stromes ausgebildet sind. Die Bestimmungsmittel sind beispielsweise zusammen mit den Thermogeneratoren auf einer Leiterplatte (vgl. Figur 4) angeordnet.

Durch den Stromtransport durch die Stromschiene 4 entsteht eine erhöhte Temperatur der Stromschiene gegenüber ihrer Umgebung, so dass ein Temperaturgradient zwischen Stromschiene 4 und dem Kühlkörper 30 entsteht, unter dessen Einwirkung die beiden Thermogeneratoren eine Thermospannung erzeugen, die zum Betrieb der Bestimmungsmittel verwendet wird. Der Wärmefluss ausgehend von der Stromschiene 4 durch die Thermogeneratoren hindurch ist in den Figuren 1 und 2 durch Pfeile angedeutet.

Die Gehäuseteile 11, 12 sowie der Arm 31 sind aus einem elektrisch nicht (oder nur schlecht) leitfähigen Material (insbesondere aus einem Kunststoff) ausgebildet. Des Weiteren besitzt die Überwachungsanordnung 1 auf einer in dem Gehäuseteil 11 abgewandten Seite des Kühlers 30 eine isolierende, plattenförmige Abdeckung 5 (die ebenfalls aus einem isolierenden Kunststoff oder einem Verbundmaterial wie z.B. FR4 hergestellt sein kann), die insbesondere dazu dient, einen Kontakt des (insbesondere aus einem Metall wie Aluminium hergestellten) Kühlkörpers 30 mit anderen unter Spannung stehenden Objekten (zum Beispiel einer benachbarten Stromschiene) zu verhindern. Die Abdeckplatte 5 ist in Draufsicht näherungsweise rechteckig ausgebildet und an einer Längseite mit dem weiteren Gehäüseteil 12 verbunden.

Wie insbesondere der Figur 2 zu entnehmen ist, weist die Abdeckung 5 eine Mehrzahl von Aussparungen 51 auf, um einen möglichst guten Wärmeabtransport von dem Kühlkörper 30 zur gewährleisten.

Die Figur 4 zeigt die Überwachungsanordnung der Figuren 1 bis 3 ohne die Gehäuseteile 11, 12 und die Verbindungsmittel 3. Die Thermogeneratoren sind allerdings auch in dieser Darstellung nicht zu erkennen, da sie sich unterhalb des Wärmeverteilers 20 auf einer Platine 50 befinden. Die Platine 50 ist mit ihrer dem Wärmeverteiler 20 abgewandten Seite mit dem Kühlkörper 30 verbunden, zum Beispiel über einen Klebstoff. Auf der Leiterplatte 50 ist auch der Stromsensor (nicht dargestellt) angeordnet.

Des Weiteren befinden sich auf der Leiterplatte Übertragungsmittel zum drahtlosen Übertragen von Informationen bezüglich der von den Bestimmungsmitteln bestimmten elektrischen Kenngröße an eine externe Empfangseinrichtung. Diese Übertragungsmittel umfassen einen elektronischen Baustein 60 sowie eine mit diesem Baustein in Verbindung stehende Antenne 61.

Auf der Platine 50 befinden sich weitere elektronische Komponenten, beispielsweise ein Mikrocontroller 70 zum Steuern der Überwachungsanordnung sowie Bauelemente zum Aufbereiten der von den Thermogeneratoren erzeugten elektrischen Spannung und/oder zur Auswertung der von den Bestimmungsmitteln bestimmten Kenngrößen sowie ein Speicherbaustein zum Speichern von elektrischer Energie der Thermogeneratoren.

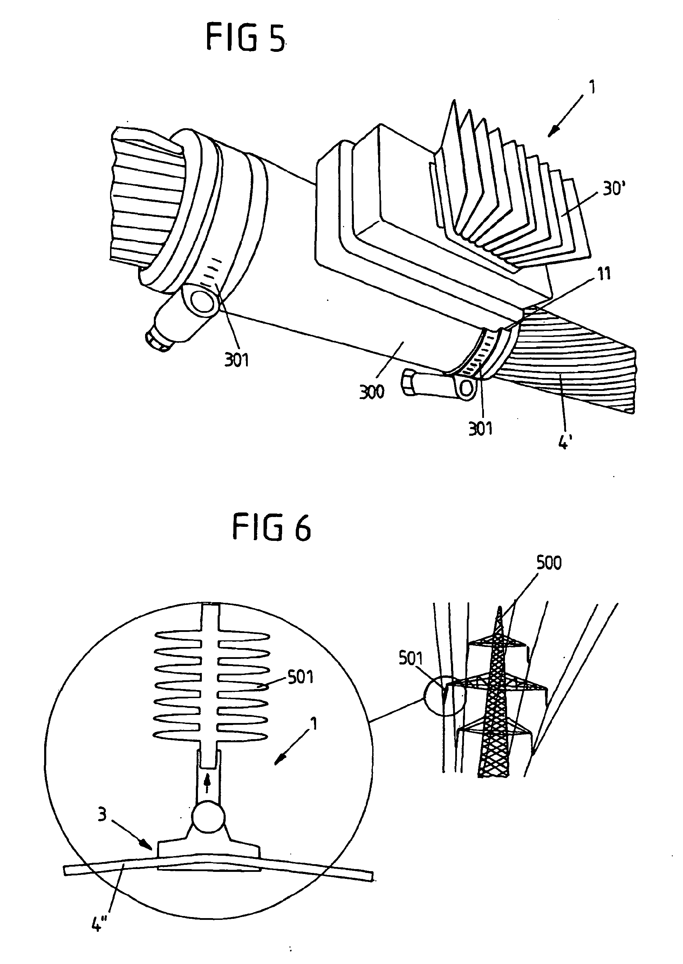

Figur 5 zeigt ein weiteres Ausführungsbeispiel einer Überwachungsanordnung 1. Im Unterschied zu dem Ausführungsbeispiel gemäß den Figuren 1 bis 4 sind die Verbindungsmittel zum Verbinden der Überwachungsanordnung mit einer elektrischen Leitung nicht in Form einer Klammer ausgebildet. Vielmehr ist das Gehäuseteil 11, das, wie in den Figuren 1 bis 3 eine Leiterplatte mit den Thermogeneratoren umschließt, mit einer Manschette 300 verbunden. Die Manschette 300 kann um eine elektrische Leitung (oder wie in Figur 5 gezeigt auch um ein Bündel 4' mehrerer elektrischer Leitungen) herum gelegt und mittels Schellen 301 an der Leitung festgelegt werden.

Im Unterschied zum Ausführungsbeispiel der Fig. 1 bis 3 ist zudem der Kühlkörper 30' fächerartig gestaltet.

Figur 6 zeigt schematisch eine andere Möglichkeit der Ausgestaltung der erfindungsgemäßen Überwachungsanordnung, wobei die Überwachungsanordnung an einer elektrischen Leitung in Form einer Überlandstromleitung 4" angeordnet ist.

Danach umfasst die Überwachungsanordnung 1 Verbindungsmittel 3, über die sie mit der stromführenden Leitung 4" verbunden werden kann. Des Weiteren umfasst die Überwachungsanordnung 1 weitere Verbindungsmittel, die eine Verbindung der Überwachungsanordnung mit einem Isolator 501, über den die elektrische Leitung 4" an einem Arm eines Strommastes 500 aufgehängt ist, ermöglichen.

Darüber hinaus sind die Bestimmungsmittel der Überwachungsanordnung 1 in Form eines Strommessers ausgebildet, über den ein von der elektrischen Leitung 4" über den Isolator 501 abfließender Strom gemessen und somit die Stromstärke des in der elektrischen Leitung 4" fließenden Stromes bestimmt werden kann.

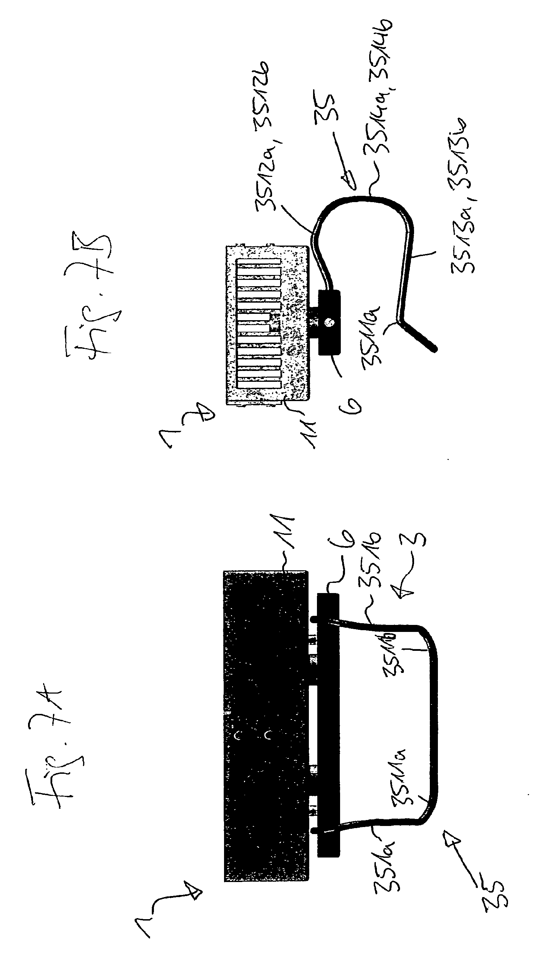

Die Fig. 7A und 7B betreffen ein weiteres Ausführungsbeispiel der Erfindung. Die Überwachungsanordnung 1 weist hier ähnlich der Fig. 1 bis 4 einen in einem Gehäuseteil 11 angeordneten Thermogenerator und/oder eine dort angeordnete Einrichtung zur induktiven Energiegewinnung auf, die jeweils zur Versorgung von zumindest teilweise ebenfalls im Gehäuseteil 11 untergebrachten Bestimmungsmitteln dienen (s.o.). Anstelle eines verschiebbaren Armes umfassen die Verbindungsmittel 3 der Überwachungsanordnung 1 jedoch eine Klammer 35, die von einem drahtförmigen Element (oder mehreren drahtförmigen Elementen) ausgeformt wird.

Die Klammer 35 weist zwei äußere, in Draufsicht (entlang der elektrischen Leitung betrachtet) jeweils zumindest näherungsweise U-förmige Teilabschnitte 351a, 351b auf, die jeweils einen unteren Anlageabschnitt 3511a, 3511b aufweisen, der nach Montage an der elektrischen Leitung (nicht dargestellt) anliegen wird. Zur Montage der Überwachungsanordnung 1 an der elektrischen Leitung wird die Klammer 35 entsprechend dem Durchmesser der elektrischen Leitung aufgebogen und auf die Leitung aufgeschoben, so dass sie gegen die Leitung vorgespannt ist eine Klemmverbindung zwischen Klammer und Leitung realisiert wird.

Beispielsweise ist die Klammer so gestaltet, dass sie bei Aufschieben auf die Leitung in einem vorgegebenen Durchmesserbereich der Leitung selbst aufbiegt - d.h. sich der Leitung anpasst.

Die seitlichen Teilabschnitte 351a, 351b erhalten ihre U-Form dadurch, dass sie jeweils einen oberen Armabschnitt 3512a, 3512b aufweisen, der an einem mit dem Gehäuseteil 11 verbundenen Träger 6 festgelegt ist, sowie einen unteren Armabschnitt 3513a, 3513b, der über einen Krümmung 3514a, 3514b mit dem oberen Armabschnitt 3512a, 3512b verbunden ist. Die Klammer 35 ermöglicht z.B. eine einhändige Montage und kann in einfacher Weise an unterschiedliche Leitungsquerschnitte angepasst werden, z.B. kann sie so konstruiert sein, dass sie an Leitungen mit einem Durchmesser zwischen 5 und 20 mm anklemmbar ist.

Möglich ist, dass die Klammer 35 aus einem elektrisch isolierenden Material hergestellt ist oder eine elektrische isolierenden Beschichtung oder einen isolierenden Überzug (und z.B. einen metallischen Kern, z.B. einen metallischen Draht) aufweist.

Es wird darauf hingewiesen, dass in sämtlichen Ausführungsbeispielen anstelle eines Thermogenerators oder zusätzlich zum Thermogenerator eine Einrichtung zur induktiven Energiegewinnung verwendet werden kann.

### Bezugszeichenliste

- 1: Überwachungsanordnung
- 3: Verbindungsmittel
- 4: Stromschiene
- 4': Leitungsbündel
- 4": Überlandleitung
- 5: Abdeckung
- 11, 12: Gehäuseteil
- 20: Wärmeverteiler
- 30, 30': Kühlkörper
- 31: Arm
- 32: Anlagebereich
- 33: Armabschnitt
- 34: Fixierschraube
- 41: Seite
- 50: Platine
- 51: Aussparung
- 60: elektronischer Baustein
- 61: Antenne
- 70: Mikrocontroller
- 111: Bodenabschnitt
- 300: Manschette
- 301: Schelle

## Patentansprüche

1. Überwachungsanordnung zur Überwachung einer elektrischen Leitung, mit
- mindestens einem Thermogenerator und/oder einer Einrichtung zur induktiven Energiegewinnung;
- Bestimmungsmitteln zum Bestimmen mindestens einer elektrischen Kenngröße eines in der elektrischen Leitung (4, 4', 4") fließenden elektrischen Stromes und/oder der Temperatur der elektrischen Leitung und/oder der Umgebung der elektrischen Leitung, wobei
- zwischen den Bestimmungsmitteln und dem Thermogenerator oder der Einrichtung zur induktiven Energiegewinnung eine elektrische Verbindung besteht oder herstellbar ist, über die die Bestimmungsmittel mit von dem Thermogenerator erzeugter o-der von der Einrichtung zur induktiven Energiegewinnung bereitgestellter elektrischer Energie betreibbar sind; und
- Verbindungsmitteln (3) zum Herstellen einer mechanischen Verbindung mit der elektrischen Leitung (4, 4', 4"),
**dadurch gekennzeichnet, dass**
die Verbindungsmittel (3) einen aus einem elektrisch isolierenden Material gebildeten oder eine elektrisch isolierende Beschichtung aufweisenden Anlagebereich (32) aufweisen, der an einer sowohl den Bestimmungsmitteln als auch dem Thermogenerator und/oder der Einrichtung zur induktiven Energiegewinnung abgewandten Seite der elektrischen Leitung (4, 4', 4") zur Anlage gebracht werden kann.

2. Überwachungsanordnung nach Anspruch 1, **dadurch gekennzeichnet, dass** die Verbindungsmittel (3) zum Herstellen einer kraft-, form- und/oder stoffschlüssigen Verbindung mit der elektrischen Leitung (4, 4', 4") ausgebildet sind.

3. Überwachungsanordnung nach Anspruche 1 oder 2, **dadurch gekennzeichnet, dass** der Anlagebereich (32) durch einen senkrecht zur elektrischen Leitung verschiebbaren Arm (31) der Verbindungsmittel ausgebildet wird, wobei insbesondere der Anlagebereich (32) durch einen gekrümmten Bereich des Armes (31) ausgebildet wird.

4. Überwachungsanordnung nach einem der Ansprüche 1 oder 2, **dadurch gekennzeichnet, dass** der Anlagebereich durch eine drahtförmige Klammer der Verbindungsmittel ausgebildet wird.

5. Überwachungsanordnung nach einem der vorhergehenden Ansprüche, **dadurch gekennzeichnet, dass** die Verbindungsmittel (3) zum Herstellen einer Magnetverbindung mit der elektrischen Leitung (4, 4', 4") ausgebildet sind.

6. Überwachungsanordnung nach einem der vorhergehenden Ansprüche, **gekennzeichnet durch** Übertragungsmittel (60, 61) zum drahtlosen Übertragen der erfassten Kenngröße und/oder einer Information bezüglich der bestimmten elektrischen Kenngröße an eine Empfangseinrichtung.

7. Überwachungsanordnung nach einem der vorhergehenden Ansprüche, **gekennzeichnet durch** einen Energiespeicher zum Speichern von elektrischer Energie, die von dem Thermogenerator erzeugt und/oder der Einrichtung zur induktiven Energiegewinnung bereitgestellt wird, wobei insbesondere der Energiespeicher erste und zweite Speichermittel aufweist, und wobei die zweiten Speichermittel eine höhere Speicherkapazität aufweisen als die ersten Speichermittel.

8. Überwachungsanordnung nach einem der vorhergehenden Ansprüche, **dadurch gekennzeichnet, dass** die Bestimmungsmittel ausgebildet sind, die Stromstärke, eine elektrische Spannung entlang der elektrischen Leitung und/oder gegenüber einem zur elektrischen Leitung externen Referenzpunkt und/oder die Phase zwischen Strom und Spannung zu bestimmen.

9. Überwachungsanordnung nach einem der vorhergehenden Ansprüche, **dadurch gekennzeichnet, dass** die Bestimmungsmittel ausgebildet sind, die elektrische Kenngröße zeitabhängig zu bestimmen und Abweichungen von einer vorgebbaren Signalform zu ermitteln.

10. Überwachungsanordnung nach Anspruch 8 oder 9, **dadurch gekennzeichnet, dass** die Bestimmungsmittel ausgebildet sind, die Frequenz, ein Frequenzspektrum und/oder eine Amplitude der elektrischen Kenngröße und/oder einen Blindstromanteil des in der elektrischen Leitung geführten elektrischen Stromes zu bestimmen.

11. Überwachungsanordnung nach Anspruch 7 oder 10, **dadurch gekennzeichnet, dass** die Bestimmungsmittel ausgebildet sind, ein Alarmsignal zu generieren, falls die Temperatur, Frequenz, die Amplitude und/oder der Blindstromanteil um einen vorgebbaren Mindestwert von einem Referenzwert abweicht.

12. Überwachungsanordnung nach einem der vorhergehenden Ansprüche, **gekennzeichnet durch** Umschaltmittel, über die die Bestimmungsmittel aus einem ersten, energiesparenden Zustand in einen zweiten, aktiven Zustand schaltbar sind.

13. Anordnung aufweisend mindestens eine elektrische Leitung (4, 4', 4") und mindestens eine an der elektrischen Leitung (4, 4', 4") angeordnete Überwachungsanordnung (1) gemäß einem der vorhergehenden Ansprüche.

14. Anordnung nach Anspruch 13, **gekennzeichnet durch** mehrere Überwachungsanordnungen (1) gemäß einem der Ansprüche 1 bis 12, wobei jede der Überwachungsanordnungen (1) Übertragungsmittel (60, 61) zum drahtlosen Übertragen der bestimmten elektrischen Kenngröße und/oder einer Information bezüglich der erfassten Kenngröße an eine Empfangseinrichtung aufweist, und wobei die Übertragungsmittel (60, 61) ausgebildet sind, Signale der Übertragungsmittel der anderen Überwachungsanordnungen zu empfangen und diese Signale an mindestens eine andere Überwachungsanordnung oder an die Empfangseinrichtung zu übermitteln.

15. Verfahren zur Überwachung einer elektrischen Leitung, mit den Schritten
- Bereitstellen einer Überwachungsanordnung, die insbesondere gemäß einem der Ansprüche 1 bis 12 ausgebildet ist, wobei die Überwachungsanordnung mindestens einen Thermogenerator und/oder eine Einrichtung zur induktiven Energiegewinnung aufweist sowie Bestimmungsmittel zum Bestimmen mindestens einer elektrischen Kenngröße eines in der elektrischen Leitung (4, 4', 4") fließenden elektrischen Stromes und/oder der Temperatur der elektrischen Leitung und/oder der Umgebung der elektrischen Leitung, wobei zwischen den Bestimmungsmitteln und dem Thermogenerator oder der Einrichtung zur induktiven Energiegewinnung eine elektrische Verbindung besteht oder herstellbar ist, über die die Bestimmungsmittel mit von dem Thermogenerator erzeugter oder von der Einrichtung zur induktiven Energiegewinnung bereitgestellter elektrischer Energie betreibbar sind; und
- Herstellen einer mechanischen Verbindung zwischen der Überwachungsanordnung und der elektrischen Leitung mittels Verbindungsmitteln (3), die einen aus einem elektrisch isolierenden Material gebildeten oder eine elektrisch isolierende Beschichtung aufweisenden Anlagebereich (32) aufweisen, der an einer sowohl den Bestimmungsmitteln als auch dem Thermogenerator und/oder der Einrichtung zur induktiven Energiegewinnung abgewandten Seite der elektrischen Leitung (4, 4', 4") zur Anlage gebracht wird.

## Claims

1. Monitoring arrangement for monitoring an electrical line with
- at least one thermogenerator and/or a device for inductively producing energy;
- determination means for determining at least one electrical characteristic parameter of an electrical current flowing in the electrical line (4, 4', 4") and/or the temperature of the electrical line and/or the surrounding of the electrical line, wherein
- an electrical connection exists or can be established between the determination means and the thermogenerator or the device for inductively producing energy, wherein via said connection the determination means can be operated with electrical energy generated by the thermogenerator or provided by the device for inductively producing energy; and
- connection means (3) for establishing a mechanical connection to the electrical line (4, 4', 4"),
**characterized in that**
the connection means (3) comprise a resting area (32) which is made of an electrical insulating material or comprises an electrical insulating coating and which can be made to rest against the side of the electrical line (4, 4', 4") facing away from the determination means as well as the thermogenerator and/or the device for inductively producing energy.

2. Monitoring arrangement according to claim 1, **characterized in that** the connection means (3) are designed for establishing a force locking, form locking and/or firmly bonded connection to the electrical line (4, 4', 4").

3. Monitoring arrangement according to claim 1 or 2, **characterized in that** the resting area (32) is formed by an arm (31) of the connection means, which is movable vertical to the electrical line, wherein particularly the resting area (32) is formed by a curved area of the arm (31).

4. Monitoring arrangement according to one of the claims 1 or 2, **characterized in that** the resting area is formed by a wire-like clamp of the connection means.

5. Monitoring arrangement according to one of the preceding claims, **characterized in that** the connection means (3) are formed for establishing a magnetic connection to the electrical line (4, 4', 4").

6. Monitoring arrangement according to one of the preceding claims, **characterized by** transfer means (60, 61) for wireless transfer of the recorded parameter and/or information regarding the specific electrical parameter to a receiving device.

7. Monitoring arrangement according to one of the preceding claims, **characterized by** an energy storage device for storing electrical energy, which is generated by the thermogenerator and/or provided by the device for inductively producing energy, wherein particularly the energy storage device comprises first and second storage means and wherein the second storage means comprise a higher storage capacity than the first storage means.

8. Monitoring arrangement according to one of the preceding claims, **characterized in that** the determination means are designed to determine the current, an electrical voltage along the electrical line and/or a reference point being external in respect to the electrical line and/or the phase between current and voltage.

9. Monitoring arrangement according to one of the preceding claims, **characterized in that** the determination means are designed to determine the electrical parameter time-dependent and to identify deviations from a defined signal form.

10. Monitoring arrangement according to claim 8 or 9, **characterized in that** the determination means are designed to determine the frequency, a frequency spectrum and/or an amplitude of the electrical parameter and/or a reactive current portion of the electrical current led in the electrical line.

11. Monitoring arrangement according to claim 7 or 10, **characterized in that** the determination means are designed to generate an alarm signal if the temperature, frequency, the amplitude and/or the reactive current portion deviates from a reference value by a defined minimal value.

12. Monitoring arrangement according to one of the preceding claims **characterized by** switching means via which the determination means can be switched from a first energy saving status in a second active status.

13. Arrangement comprising at least on electrical line (4, 4', 4") and at least one monitoring arrangement (1) arranged on the electrical line (4, 4', 4") according to one of the preceding claims.

14. Arrangement according to claim 13, **characterized by** multiple monitoring arrangements (1) according to one of the claims 1 to 13, wherein each of the monitoring arrangements (1) comprises transfer means (60, 61) for wireless transfer of the determined electrical parameter and/or an information relating to the recorded parameter to a receiving device, and wherein the transfer means (60, 61) are designed to receive signals of the transfer means of the other monitoring arrangements and to transfer these signals to at least one other monitoring arrangement or to the receiving device.

15. Method for monitoring an electrical line with the steps
- providing a monitoring arrangement which, which is designed in particular according to one of the claims 1 to 13, wherein the monitoring arrangement comprises at least one thermogenerator and/or a device for inductively producing energy as well as determination means for determining at least one electrical parameter of a electrical current flowing in the electrical line (4, 4', 4") and/or the temperature of the electrical line and/or the surrounding of the electrical line, wherein an electrical connection exists or can be established between the determination means and the thermogenerator or the device for inductively producing energy, via which the determination means can be operated with electrical energy generated by the thermogenerator or provided by the device for inductively producing energy; and
- establishing a mechanical connection between the monitoring arrangement and the electrical line by means of connection means (3) which comprise a resting area (32) which is made of an electrical insulating material or comprises an electrical insulating coating and which is made to rest against the side of the electrical line (4, 4', 4") facing away from the determination means as well as the thermogenerator and/or the device for inductively producing energy.

## Revendications

1. Ensemble de surveillance servant à surveiller une ligne électrique, comprenant
- au moins un thermogénérateur et/ou un système servant à collecter de manière inductive de l'énergie,
- des moyens de détermination servant à déterminer au moins une grandeur caractéristique électrique d'un courant électrique parcourant la ligne électrique (4, 4', 4") et/ou à déterminer la température de la ligne électrique et/ou de l'environnement de la ligne électrique, où
- une liaison électrique est établie ou peut être établie entre les moyens de détermination et le thermogénérateur ou le système servant à collecter de manière inductive de l'énergie, ladite liaison électrique permettant de faire fonctionner les moyens de détermination avec l'énergie électrique produite par le thermogénérateur ou fournie par le système servant à collecter de manière inductive de l'énergie ; et
- des moyens de liaison (3) servant à établir une liaison mécanique avec la ligne électrique (4, 4', 4"),
**caractérisé en ce**
**que** les moyens de liaison (3) présentent une zone d'appui (32) formée à partir d'un matériau à isolation électrique ou présentant un revêtement à isolation électrique, laquelle zone d'appui peut être amenée en appui sur un côté de la ligne électrique (4, 4', 4"), qui est opposé aussi bien aux moyens de détermination qu'au thermogénérateur et/ou au système servant à collecter de manière inductive de l'énergie.

2. Ensemble de surveillance selon la revendication 1, **caractérisé en ce que** les moyens de liaison (3) sont réalisés afin d'établir une liaison à force, par complémentarité de forme et/ou par liaison de matière avec la ligne électrique (4, 4', 4").

3. Ensemble de surveillance selon la revendication 1 ou 2, **caractérisé en ce que** la zone d'appui (32) est réalisée par un bras (31) des moyens de liaison qui peut être déplacé par coulissement de manière perpendiculaire par rapport à la ligne électrique, la zone d'appui (32) en particulier étant réalisée par une zone incurvée du bras (31).

4. Ensemble de surveillance selon l'une quelconque des revendications 1 ou 2, **caractérisé en ce que** la zone d'appui est réalisée par une bride de fixation en forme de fil des moyens de liaison.

5. Ensemble de surveillance selon l'une quelconque des revendications précédentes, **caractérisé en ce que** les moyens de liaison (3) sont réalisés pour établir une liaison magnétique avec la ligne électrique (4, 4', 4").

6. Ensemble de surveillance selon l'une quelconque des revendications précédentes, **caractérisé par** des moyens de transmission (60, 61) servant à transmettre sans fil à un système de réception la grandeur caractéristique détectée et/ou une information concernant la grandeur caractéristique électrique déterminée.

7. Ensemble de surveillance selon l'une quelconque des revendications précédentes, **caractérisé par** un accumulateur d'énergie servant à stocker de l'énergie électrique, qui est produite par le thermogénérateur et/ou qui est fournie par le système servant à collecter de manière inductive de l'énergie, l'accumulateur d'énergie en particulier présentant des premiers et des deuxièmes moyens de stockage, et les deuxièmes moyens de stockage présentant une capacité de stockage plus importante que les premiers moyens de stockage.

8. Ensemble de surveillance selon l'une quelconque des revendications précédentes, **caractérisé en ce que** les moyens de détermination sont réalisés pour déterminer l'intensité du courant, une tension électrique le long de la ligne électrique et/ou par rapport à un point de référence externe par rapport à la ligne électrique et/ou pour déterminer la phase entre le courant et la tension.

9. Ensemble de surveillance selon l'une quelconque des revendications précédentes, **caractérisé en ce que** les moyens de détermination sont réalisés pour déterminer, en fonction du temps, la grandeur caractéristique électrique et pour déterminer des écarts d'une forme de signal pouvant être prédéfinie.

10. Ensemble de surveillance selon la revendication 8 ou 9, **caractérisé en ce que** les moyens de détermination sont réalisés pour déterminer la fréquence, un spectre de fréquences et/ou une amplitude de la grandeur caractéristique électrique et/ou une part de courant réactif du courant électrique acheminé dans la ligne électrique.

11. Ensemble de surveillance selon la revendication 7 ou 10, **caractérisé en ce que** les moyens de détermination sont réalisés pour générer un signal d'alarme en cas d'écart de la température, de la fréquence, de l'amplitude par rapport à une valeur de référence et/ou en cas d'écart de la part de courant réactif d'une valeur minimale pouvant être prédéfinie par rapport à une valeur de référence.

12. Ensemble de surveillance selon l'une quelconque des revendications précédentes, **caractérisé par** des moyens de commutation, lesquels permettent de commuter les moyens de détermination d'un premier état à économie d'énergie dans un deuxième état actif.

13. Ensemble présentant au moins une ligne électrique (4, 4', 4") et au moins un ensemble de surveillance (1) disposé au niveau de la ligne électrique (4, 4', 4") selon l'une quelconque des revendications précédentes.

14. Ensemble selon la revendication 13, **caractérisé par** plusieurs ensembles de surveillance (1) selon l'une quelconque des revendications 1 à 12, où chacun des ensembles de surveillance (1) présente des moyens de transmission (60, 61) servant à transmettre sans fil à un ensemble de réception la grandeur caractéristique électrique déterminée et/ou une information concernant la grandeur caractéristique détectée, et sachant que les moyens de transmission (60, 61) sont réalisés pour recevoir des signaux des moyens de transmission des autres ensembles de surveillance et pour transmettre lesdits signaux à au moins un autre ensemble de surveillance ou au système de réception.

15. Procédé de surveillance d'une ligne électrique, comprenant les étapes suivantes consistant à :
- fournir un ensemble de surveillance, qui est réalisé en particulier selon l'une quelconque des revendications 1 à 12, où l'ensemble de surveillance présente au moins un thermogénérateur et/ou un système servant à collecter de manière inductive de l'énergie, ainsi que des moyens de détermination servant à déterminer au moins une grandeur caractéristique électrique d'un courant électrique parcourant la ligne électrique (4, 4', 4") et/ou servant à déterminer la température de la ligne électrique et/ou de l'environnement de la ligne électrique, sachant qu'une liaison électrique est établie ou peut être établie entre les moyens de détermination et le thémogénérateur ou l'ensemble servant à collecter de manière inductive de l'énergie, laquelle ligne électrique permet de faire fonctionner les moyens de détermination avec l'énergie électrique produite par le thermogénérateur ou fournie par le système servant à collecter de manière inductive de l'énergie ; et
- établir une liaison mécanique entre l'ensemble de surveillance et la ligne électrique au moyen de moyens de liaison (3), qui présentent une zone d'appui (32) formée à partir d'un matériau à isolation électrique ou présentant un revêtement à isolation électrique, laquelle zone d'appui peut être amenée en appui sur un côté de la ligne électrique (4, 4', 4"), lequel côté est opposé aussi bien aux moyens de détermination qu'au thermogénérateur et/ou au système servant à collecter de manière inductive de l'énergie.
